(19) Europäisches Patentamt

European Patent Office

Office européen des brevets

(11) **EP 0 785 619 A2**

(12) **EUROPÄISCHE PATENTANMELDUNG**

(43) Veröffentlichungstag:
23.07.1997 Patentblatt 1997/30

(51) Int. Cl.⁶: **H03H 9/00**

(21) Anmeldenummer: 97100542.6

(22) Anmeldetag: 15.01.1997

(84) Benannte Vertragsstaaten:
DE FR GB IT

(30) Priorität: 22.01.1996 DE 19602125

(71) Anmelder: SIEMENS AKTIENGESELLSCHAFT
80333 München (DE)

(72) Erfinder:
• Feldmann, Jörg-Uwe, Dr.
  81827 München (DE)
• Schmidt-Kreusel, Christof
  47057 Duisburg (DE)
• Zheng, Qinghua, Dr.
  82024 Taufkirchen (DE)

(54) **Verfahren zur rechnergestützten iterativen Bestimmung des Einschwingverhaltens einer Quarzresonatorschaltung**

(57) Die Erfindung betrifft ein Verfahren, bei dem nach einer Arbeitspunktbestimmung der Quarzresonatorschaltung eine Substitution der Ersatzschaltung des Quarzresonators durch eine unabhängige Stromquelle mit der initialen, zuvor ermittelten Amplitude des Stroms des dynamischen Arms des Quarzresonators durchgeführt.

Für diese Schaltungsanordnung wird mittels Schießverfahren oder Verfahren der Harmonischen Balance, also im Frequenzbereich, der dynamische Gleichgewichtszustand ermittelt. Nach einer Rücksubstitution der Stromquelle durch das Ersatzschaltbild des Quarzresonators wird eine Transientenanalyse für den dynamischen Gleichgewichtszustand durchgeführt. Dieses Verfahren wird iterativ solange durchgeführt, solange die ermittelte Wachstumsrate $\alpha_i$ über einer vorgebbaren Schranke liegt.

EP 0 785 619 A2

## Beschreibung

Die Erfindung betrifft ein Verfahren mit dem es möglich wird, eine Klasse von Schaltungen einer Behandlung im Rahmen des rechnergestützten Schaltungsentwurfs zugänglich zu machen. Diese sind Quarzoszillatoren mit hoher effektiver Güte zur Erzeugung hochgenauer Frequenznormale. Die Bedeutung dieser Schaltungsart wird evident, wenn man bedenkt, daß mit deren Hilfe zum ersten Mal Gangungenauigkeiten von Pendeluhren, hervorgerufen durch den Gravitationseinfluß des Mondes, und ebenso schwache Unregelmäßigkeiten in der Rotationsperiode der Erde nachgewiesen werden konnten.

Obwohl allein in der Bundesrepublik Deutschland durchschnittlich mehr als sieben Quarzresonatoren pro Haushalt Anwendung finden und dieses Bauelement damit in der Tat eine sehr weite Verbreitung besitzt, existiert bis dato kein Werkzeug, mit dessen Hilfe professionelle Entwickler in Industrie und Technik die von ihnen benötigten Schaltungen „online" am Rechner testen und optimieren können.

Im Gegensatz zu der Einschätzung, daß es nicht allzu schwer ist, einen funktionierenden Quarzoszillator aufzubauen, ist der Entwurf hochwertiger Oszillatoren dem allgemein mit Elektrotechnik Befaßten nur vage und in Bruchstücken bekannt.

Die Bestimmung des Einschwingverhaltens mittels eines bekannten Verfahrens, der sogenannten Transientenanalyse von schwach stabilen Systemen [1] birgen bei der Anwendung der Transientenanalyse auf Quarzresonatorschaltungen vor allem den Nachteil in sich, daß sie rein quantitativ eine zu hohe Anforderung an jede Recheneinheit stellen.

Dies wird ersichtlich, da bei der Simulation von Quarzoszillatoren extreme Einschwingzeiten - nach dem Anstoßen des Systems durch das Hochfahren der Betriebsspannung - zu beobachten ist und somit die Notwendigkeit gegeben ist, innerhalb einer traditionellen Transientenanalyse [1] eine sehr große Anzahl von Perioden berechnen zu müssen, bis ein eingeschwungener Zustand vorliegt.

Die Dauer des Einschwingvorganges hängt von dem gewählten Arbeitspunkt und der Güte des Resonators ab.

Als gültige Faustregel kann die Einschwingzeit $t_f$ abgeschätzt werden zu $t_f = 10^4$ bis $10^7$ x T, wobei T eine Periode der Schwingung der Resonatorspannung bezeichnet.

Legt man eine „Abtastrate" der Grundschwingung von 50 zugrunde, ergäbe dies für dieses Beispiel ein Aufwand von minimal 500.000 Integrationsschritten. Dieser Aufwand sorgt dafür, daß selbst kleinste Schaltungen mit moderater Güte und bei einer Forderung einer sinnvollen Genauigkeit Rechenzeiten von 6 bis 8 Stunden auf einer modernen Workstation erfordern. Bei größeren Schaltungen und wachsender Güte des Resonators läßt sich dieser Aufwand fast beliebig steigern. Insgesamt können Rechenzeiten von mehreren Wochen resultieren, die einhergehen mit einem enormen Speicherplatzbedarf für die anfallenden Daten während der Ermittlung des Einschwingverhaltens der Quarzresonatorschaltung.

Dieses Problem der immensen Rechenzeitanforderungen wird versucht, ansatzweise durch das aus [2] bekannte Verfahren zu lösen. Bei diesem Verfahren wird innerhalb des Ersatzschaltbildes des Quarzresonators, welches eine Resonatorinduktivität $L_m$ sowie eine Resonatorkapazität $C_m$ und einen Resonatorwiderstand $R_m$ aufweist, die Resonatorinduktivität $L_m$ erniedrigt und die Resonatorkapazität $C_m$ erhöht. Weiterhin wird der Resonatorwiderstand $R_m$ unverändert gelassen. Damit kann in der Tat die Schwingfähigkeit des Systems überprüft werden. Die Einschwingzeit und wichtige Größen wie die sich einstellende Frequenz der Resonatorschaltung sind daraus allerdings nicht ableitbar. Dies stellt einen erheblichen Nachteil dieses bekannten Verfahrens dar, da als Problem noch immer enorme Einschwingzeiten verbleiben.

Der Erfindung liegt somit das Problem zugrunde, ein Verfahren zur rechnergestützten iterativen Bestimmung des Einßchwingverhaltens einer Quarzresonatorschaltung anzugeben, welches die benötigte Rechenkapazität zur Durchführung des Verfahrens auf einem Rechner erheblich reduziert.

Das Problem wird durch das Verfahren gemäß Patentanspruch 1 gelöst.

Bei dem Verfahren wird nach Ermittlung einer initialen Amplitude des Stroms des dynamischen Arms des Quarzresonators der Arbeitspunkt der gesamten Schaltung ermittelt. Das Ersatzschaltbild des Serienarms des Quarzresonators wird nun substituiert durch eine Stromquelle, die einen Strom der Größe der initialen Amplitude, die im vorherigen Schritt ermittelt wurde, liefert.

Für die Quarzresonatorschaltung mit der substituierten Stromquelle wird nunmehr beispielsweise mittels einem Schießverfahren oder mittels einem Verfahren der Harmonischen Balance ein dynamischer Gleichgewichtszustand ermittelt.

Nachdem der dynamische Gleichgewichtszustand ermittelt wurde, wird nun wiederum das Ersatzschaltbild des Quarzresonators rücksubstituiert und tritt somit an die Stelle der Stromquelle.

Für den zuvor ermittelten dynamischen Gleichgewichtszustand der Quarzresonatorschaltung wird nunmehr mittels einer Transientenanalyse eine Wachstumsrate der Amplitude des Stroms des dynamischen Arms des Quarzresonators ermittelt. Diese Schritte werden iterativ solange durchgeführt, bis die Wachstumsrate für den jeweiligen Iterationsschritt kleiner ist als eine vorgebbare Schwelle. Für jeden Iterationsschritt werden diese Verfahrensschritte neu durchgeführt, abhängig von der Größe der Wachstumsrate der Amplitude des Stroms des dynamischen Arms des Quarzresonators. Dies erfolgt mit einem in der Amplitude erhöhten Strom des dynamischen Arms des Quarzresonators für den Fall, daß die Wachstumsrate in dem vorangegangenen Iterationsschritt größer ist als Null sowie mit einem in der Amplitude erniedrigten Strom, falls die Wachstumsrate kleiner als Null ist.

Alle ermittelten Wachstumsraten, die einen Wert aufweisen, der größer ist als Null, werden gespeichert und aus dieser Folge der Wachstumsraten wird schließlich das Einschwingverhalten der Quarzresonatorschaltung bestimmt.

Dadurch wird erstmals eine Möglichkeit vorgestellt, das Einschwingverhalten in bezüglich der Rechenzeitanforderungen akzeptablen Dimensionen durchzuführen. Der entscheidende Vorteil des erfindungsgemäßen Verfahrens besteht darin, daß das Hochfahren der substituierten Quelle in verglichen mit der Periodendauer der oszillatorischen Schwingung großen Schritten erfolgen kann. Das bedeutet, daß den einzelnen deutlich separierten Amplitudenwerten der Quelle auf der Zeitachse ein Abstand von unter Umständen mehreren zehntausend Perioden entspricht.

Somit wird die Einschwingcharakteristik nur punktweise - und versehen mit einer passenden Phasenbedingung, der Einhüllenden folgend - berechnet.

Aus diesen zeitlich lokal extrahierten Größen wird das globale Verhalten rekonstruiert und somit die Einschwingcharakteristik bestimmt.

Weiterbildungen der Erfindung ergeben sich aus den abhängigen Ansprüchen.

So ist es beispielsweise vorteilhaft, zur Bestimmung des dynamischen Gleichgewichtszustands sogenannte Schießverfahren zu verwenden.

Alternativ dazu ist es jedoch auch vorteilhaft, zur Bestimmung des dynamischen Gleichgewichtszustands das sogenannte Verfahren der Harmonischen Balance einzusetzen.

Ebenso ist es vorteilhaft, zur Modellierung der zu berechnenden Schaltung das Negativ-Widerstands-Modell zu verwenden.

In einer Weiterbildung des Verfahrens ist es vorteilhaft, die Bestimmung des Einschwingverhaltens in der Weise vorzunehmen, daß aus der Folge der gespeicherten Wachstumsraten eine Folge von Zeitschritten bestimmt wird, und aus dieser Folge von Zeitschritten die Einschwingzeit der Quarzresonatorschaltung sich ergibt aus der Summe der Folge der Zeitschritte.

Im folgenden wird anhand von Zeichnungen, die ein Ausführungsbeispiel der Erfindung darstellen, das erfindungsgemäße Verfahren näher erläutert.

Es zeigen

Figur 1      einen Schaltkreis, bei dem der Quarzresonator in Forme eines Ersatzschaltbildes dargestellt ist, das gekoppelt ist mit der restlichen Schaltung, an die der Quarzresonator gekoppelt ist;

Figur 2      einen Schaltkreis, bei dem ein Serienarm des Ersatzschaltbildes des Quarzresonators dargestellt ist, das gekoppelt ist mit der restlichen Schaltung und dem Parallelarm des des Ersatzschaltbildes des Quarzresonators, die modelliert werden in einem Negativ-Widerstands-Modell;

Figur 3      ein Ablaufdiagramm, das einzelne Verfahrensschritte des erfindungsgemäßen Verfahrens beschreibt.

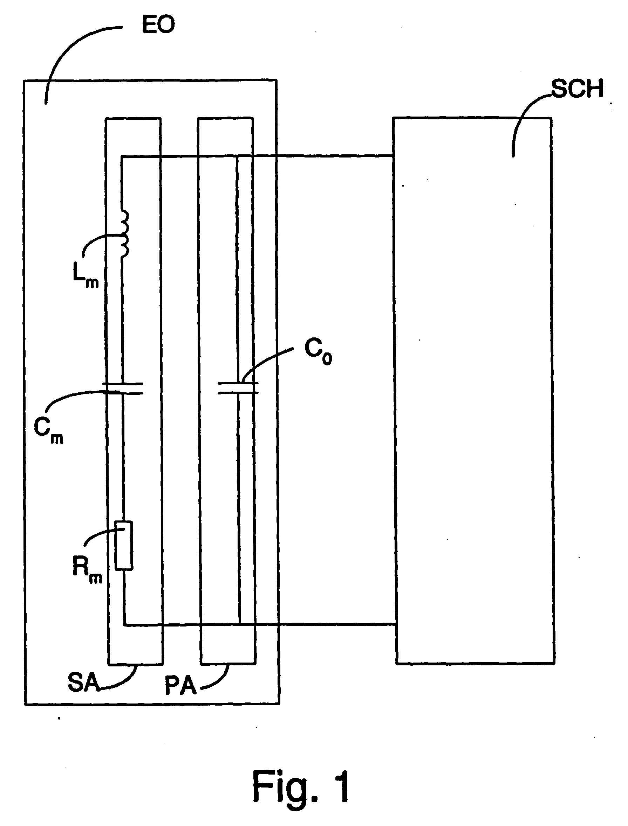

Anhand der Figuren 1 bis 3 wird das erfindungsgemäße Verfahren weiter erläutert.

In Figur 1 ist ein Ersatzschaltbild EO eines zu modellierenden Quarzresonators dargestellt.

Das Ersatzschaltbild EO weist folgende Komponenten auf:

- einen Serienarm SA mit einer Resonatorinduktivität $L_m$, einer Resonatorkapazität $C_m$ sowie einem Resonatorwiderstand $R_m$, und
- einen Parallelarm PA mit einer Parallelkapazität $C_0$.

Das Ersatzschaltbild EO und damit der Quarzresonator ist gekoppelt mit einer beliebigen Schaltung SCH.

Für das erfindungsgemäße Verfahren erweist es sich als vorteilhaft, die Parallelkapazität $C_0$ bei der Ermittlung der Schaltungsgrößen der Schaltung SCH zuzuordnen.

Somit wird in dem weiteren Verfahren nur noch der Serienarm SA des Ersatzschaltbildes EO mit einer im weiteren beschriebenen unabhängigen Stromquelle substituiert.

Für die Schaltung SCH, die eine beliebige Schaltungsanordnung aufweisen kann, wird angenommen, daß die Schaltung SCH aktiv ist, also Energie an den Serienarm SA „liefert". Diese Annahme ist notwendig für ein Schwingen des Quarzoszillators, da das Ersatzschaltbild EO den passiven Resonatorwiderstand $R_m$ aufweist.

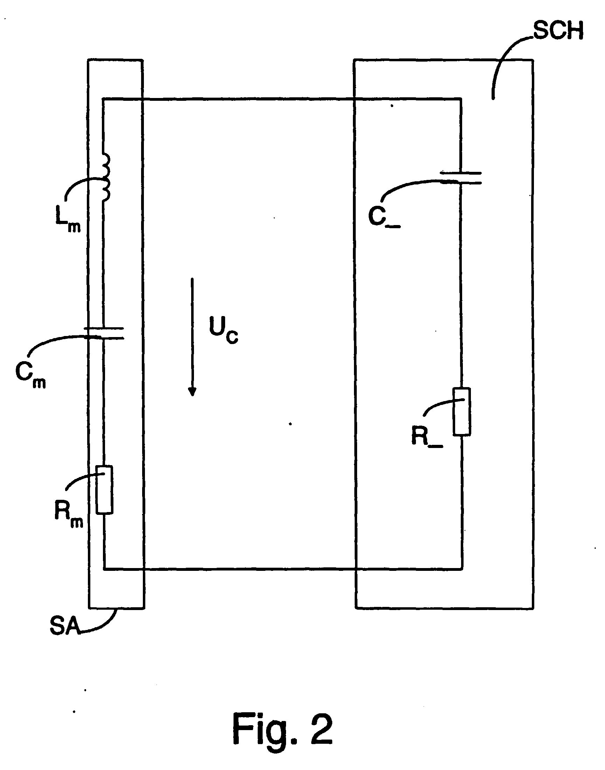

Der Serienarm SA benötigt also Energie, damit die Voraussetzung zum Schwingen des Quarzoszillators erfüllt ist. Diese Energie liefert die Schaltung SCH. Die Notwendigkeit einer aktiven Schaltung SCH wird in einem sogenannten Negativ-Widerstands-Modell berücksichtigt. Hierbei wird die Schaltung SCH, zuzüglich dem Parallelarm PA, also der Parallelkapazität $C_0$, als eine Serienschaltung aus einer Lastkapazität $C_L$ und einem Lastwiderstand $R_L$ modelliert. Von dem Lastwiderstand $R_L$ wird die zum Schwingen benötigte Energie im Rahmen dieses Modells geliefert (vgl. Figur 2).

Das erfindungsgemäße Verfahren kann vorteilhafter Weise eingesetzt werden zur Designverifikation bei dem Entwurf von Quarzresonatorschaltungen.

Das hier dargestellte Verfahren basiert auf einigen Annahmen, bei deren zumindest näherungsweisen Korrektheit die Qualität des Verfahrens sehr gut ist.

Zum einen geht das Verfahren von einer hohen Güte der Quarzresonatoren aus und leitet sich direkt aus den Konstanten ab, die den Quarz als piezoelektrisches Material charakterisieren und die somit weitestgehend von der Art und Weise der Herstellung des Quarzes abhängen, in der Größenordnung jedoch festgelegt sind.

Damit besteht ein prinzipieller Zusammenhang zwischen den geometrischen Abmessungen und den Schnittdaten des Quarzes sowie dem elektrischen Verhalten des Quarzresonators innerhalb der Quarzresonatorschaltung.

Je höher die Güte des Quarzresonators ist, desto bessere Ergebnisse liefert das erfindungsgemäße Verfahren.

Weiterhin liefert das erfindungsgemäße Verfahren nur Aussagen über die Grundwelle oder eine beliebige harmonische der Schwingungsmoden. Eine Berücksichtigung auch der Nebenresonanzen (sogenannte spurious modes) erfolgt durch das erfindungsgemäße Verfahren nicht. Dies stellt jedoch keinen bedeutenden Nachteil dar, da diese Nichtberücksichtigung von Nebenresonanzen traditionell ohnehin üblich ist. Die unmittelbare Folgerung aus dieser Festlegung für die Entwurfsseite ist somit die Forderung an den Entwickler, ohne Rückgriff auf die numerische Simulation dafür Sorge zu tragen, daß der Quarzoszillator nicht auf einer unerwünschten Frequenz schwingt oder etwa auf mehreren Frequenzen.

Auch das bei vor allem schlecht gearbeiteten Quarzen auftretende nichtlineare Verhalten bei hoher Belastung, die hohen Resonatorströme, werden durch das erfindungsgemäße Verfahren nicht berücksichtigt. Dies bedeutet, daß die Elemente des elektrischen Ersatzschaltbildes von der Aussteuerung abhängige Werte aufweisen.

**Annahmen über den Einschalt- und Anschwingvorgang.**

Eine bei der klassischen Analyse von nichtlinearen Systemen immer wieder vernachläßigte bzw. als (wie selbstverständlich) bekannt vorausgesetzte Einflußgröße ist ein Satz von verwendeten Anfangswerten $y(0)$, der das Differentialgleichungssystem $F(y, \dot{y}, t)$ erst zu einem vollwertigen Anfangswertproblem abschließt.

Eine in diesem Zusammenhang wichtige Frage ist, wie ein nicht allzu sprungförmig angenommener Einschaltvorgang, etwa ein durch

$$U_{op}(t) = U_0 \cdot \left(1 - e^{-\frac{t}{\tau_{op}}}\right) \tag{1}$$

modelliertes Verhalten der Betriebsspannung $U_{op}$ sich im initialen elektrischen Verhalten des Resonators wiederspiegelt.

Hierbei bezeichnen $U_0$ eine Endbetriebsspannung sowie $\tau_{op}$ eine Einschaltzeitkonstante. Mit $t$ wird die Zeit bezeichnet.

Dies bedeutet konkret, daß Abschätzungen der Werte einer zweiten einzuführenden Zeitkonstante $\tau_0$ und einer initialen Amplitude $U_{R,0}$ der externen Resonatorspannung, die gemäß

$$U_R(t) = U_{R,0} \cdot \left(1 - e^{-\frac{t}{\tau_0}}\right) \tag{2}$$

modelliert wird, gemacht werden müssen.

Eine dritte Zeitkonstante kann eingeführt werden, wenn man berücksichtigt, daß der eigentliche Arbeitspunkt der Schaltung nur verzögert erreicht wird. Dies wird durch eine Arbeitspunkt-Zeitkonstante $\tau_{AP}$ beschrieben.

Das erfindungsgemäße Verfahren basiert auf einer weiteren Annahme, nämlich daß der Einschaltvorgang als sehr schnell im Vergleich zu der Zeitkonstante $\tau_0$ und einer Arbeitspunkt-Zeitkonstanten $\tau_{AP}$ angenommen wird. Dies bedeutet

$$\tau_{op} \ll \tau_0, \tau_{AP} \tag{3}$$

Unter normalen Umständen ist diese Bedingung ohne weiteres erfüllt.

Weiterhin wird einsichtig, warum Manipulationen der Betriebsspannung, wie etwa ein äußerst verzögertes Hochziehen der Betriebsspannung, innerhalb des vorgestellten Verfahrens nicht berücksichtigt werden kann. Nur wenn der Einschaltvorgang als Vorgang von der Dauer maximal einiger Perioden der zugrundliegenden Arbeitsfrequenz angenommen wird, sind die für das erfindungsgemäße Verfahren notwendige Überlegungen gültig.

Der mit einer komplexen Frequenz $s = j \times \omega$ ausgedrückte Übertragungsleitwert des Serienarms des Quarzresonators ist (vgl. Figur 2):

$$H(s) = \frac{1}{R + s \cdot L + \dfrac{1}{s \cdot C}} \tag{4}.$$

Hierbei wurde zur besseren Übersichtlichkeit der Index m der Resonatorelemente weggelassen.

Geht man weiterhin davon aus, daß der Quarzresonator für die gemäß Formel (2) wachsende externe Spannung einen Leerlauf darstellt und beide Größen somit korreliert sind, dann erhält man für die Laplace-Transformierte des Resonatorstroms $I_L$ mit einer Konstanten

$$c = \frac{1}{\tau_0}$$

den folgenden Ausdruck:

$$L\{I_L\} = U_{R,0} \cdot \frac{c}{s(s+c)} \cdot \frac{1}{R + s \cdot L + \dfrac{1}{s \cdot C}} \tag{5}$$

$$= \frac{U_{R,0}}{L \cdot \tau_0} \cdot \frac{1}{(s+c)} \cdot \frac{1}{s^2 + s\dfrac{R}{L} + \dfrac{1}{L \cdot C}}$$

Nach einigen Umformungen erhält man:

$$L\{I_L\} = \frac{U_{R,0}}{L \cdot \tau_0} \cdot \frac{1}{s+c} \cdot \frac{1}{a} \cdot \frac{a}{(s+b)^2 + a^2} \tag{6}$$

$$= \frac{U_{R,0}}{L \cdot \tau_0} \cdot \frac{1}{a} \cdot L\{e^{-(b+c) \cdot t}\} \cdot L\{\sin(a \cdot t)\}$$

mit

$$b^2 = \left(\frac{R}{2L}\right)^2$$

und

$$a^2 = \frac{1}{L \cdot C} - b^2 .$$

Anwendung des Faltungssatzes sowie die Zuhilfenahme einer Rekursionsformel für das auftretende Integral liefert für den Resonatorstrom:

$$I_L(t) = \frac{U_{R,0}}{L \cdot \tau_0 \cdot a} \cdot \frac{-(b+c)}{(b+c)^2 + a^2} \cdot \left[ -e^{-(b+c) \cdot t} \cdot \frac{a}{b+c} \cdot \sin(a \cdot t) + \frac{a}{b+c} \cdot \cos(a \cdot t) \right] \tag{7}$$

Somit ergibt sich nach Substitution von

$$\cos \varphi = \frac{b+c}{\sqrt{a^2 + b^2 + c^2 + 2bc}} \tag{8}$$

$$\sin \varphi = \frac{a}{\sqrt{a^2 + b^2 + c^2 + 2bc}}$$

folgender Ausdruck für den Resonatorstrom $I_L(t)$ abhängig von der Zeit t:

$$(t) = \frac{U_{R,0}}{L \cdot \tau_0^{\ L} \cdot a} \cdot \frac{1}{\sqrt{a^2 + b^2 + c^2 + 2bc}} [\sin(a \cdot t - \varphi) + \sin \varphi \cdot e^{-(b+c) \cdot t}] \qquad (9)$$

$$= I_{L,0}[\sin(a \cdot t - \varphi) + \sin \varphi \cdot e^{-(b+c) \cdot t}]$$

Die Amplitude des Resonatorstroms $I_{L,0}$ ergibt sich zu:

$$_{,0} = \frac{U_{R,0}}{L \cdot \tau_0 \cdot a} \cdot \frac{1}{\sqrt{a^2 + b^2 + c^2 + 2bc}} \qquad \begin{array}{c} L \\ (10) \end{array}$$

$$= \frac{U_{R,0}}{L \cdot \tau_0} \cdot \frac{1}{\sqrt{\frac{1}{L \cdot C} - \left(\frac{R}{2L}\right)^2}} \cdot \frac{1}{\sqrt{\frac{1}{\tau_0^2} + \frac{R}{L \cdot \tau_0} + \frac{1}{L \cdot C}}}$$

Somit ergibt sich ein Ausdruck, der für die gemachten Annahmen das Verhalten des Resonatorstromes nach dem Anlegen der Betriebsspannung akkurat beschreibt.

Der Index 0 sollte hierbei nicht mißverstanden werden als Ausdruck t = 0. Die Bezeichnung deutet lediglich an, daß es sich um den initialen Strom handelt, der sich nach wenigen Perioden einstellt.

Durch die folgende Annahme

$$\frac{1}{L \cdot C} >> \left(\frac{R}{2L}\right)^2 \qquad (11)$$

erhält man die initiale Amplitude $I_{L,0}$ des Stroms des dynamischen Arms des Quarzresonators, dem Serienarm SA, durch:

$$_{L,0} = U_{R,0} \cdot C \cdot \frac{1}{\sqrt{L \cdot C + R \cdot C \cdot \tau_0 + \tau_0^2}} \qquad (12).$$

Durch die weitere Annahme

$$R \cdot C \cdot \tau_0 << L \cdot C \qquad (13)$$

ergibt sich ein sehr einfacher Ausdruck für die initiale Amplitude $I_{L,0}$ des Resonatorstroms:

$$_{L,0} = U_{R,0} \cdot C \cdot \frac{1}{\sqrt{L \cdot C + \tau_0^2}} = \frac{U_{R,0} \cdot C \, \omega}{\sqrt{1 + (\omega \cdot \tau_0)^2}} \qquad (14).$$

Die vorgestellte Ermittlung der initialen Amplitude $I_{L,0}$ des Resonatorstroms geht in ihren Grundzügen auf das Dokument [4] zurück.

Eine weitere, dem Algorithmus zugrundeliegende Annahme bezüglich des Anschwingvorgangs lautet:

$$U_{R,0} = U_{R,AP} \qquad (15).$$

Daraus ergibt sich für die initiale Amplitude $I_{L,0}$ des Resonatorstroms:

$$_{L,0} = U_{R,0} \cdot C \cdot \frac{1}{\sqrt{L \cdot C + \tau_0^2}} \qquad (16).$$

$$= U_{R,AP} \cdot \omega \cdot C \cdot \frac{1}{\sqrt{1 + \omega^2 \cdot \tau_0^2}}$$

Dies ist gleichbedeutend damit, daß nicht nur initiale Strom im Resonator durch eine Arbeitspunktberechnung bestimmt ist, sondern ebenso alle anderen Netzwerkgrößen auch. Die Wirkung der Arbeitspunkt-Zeitkonstanten $\tau_{AP}$ wird somit nicht berücksichtigt, was allerdings dann gerechtfertigt ist, wenn eine weitere im folgenden beschriebene Resonatorzeitkonstante $\tau r$ in ihrem Wert dominant ist.

Wird das in Figur 2 dargestellten Negativ-Widerstands-Modell im weiteren angenommen, so ist das Ersatzschaltbild EO des Quarzresonators kapazitiv mit der Lastkapazität C_ und dem Lastwiderstand R_ beschaltet. Mit der Lastkapazität C_ und der Lastwiderstand R_ wird die Schaltung SCH zuzüglich dem Parallelarm PA des Ersatzschaltbildes EO modelliert.

Nach Aufstellen der bekannten Differentialgleichungen eines Schwingkreises zweiter Ordnung sowie der Lösung des charakteristischen Polynoms ergibt sich nach in beispielsweise [5] gemachten Näherungen als Lösung für dieses System:

$$I_L(t) = I_L(0)e^{\alpha \cdot t} \cdot \cos(\omega \cdot t - \vartheta) \tag{17}.$$

Diese Lösung besteht aus einer zugrundeliegenden Schwingung $\cos(\omega t - \vartheta)$, die mit einer durch den exponentiellen Term $e^{\alpha t}$ bestimmten Einhüllenden moduliert wird.

Dieses System besitzt nur dann eine aufklingende Lösung, wenn der Koeffizient $\alpha$ einen positiven Wert besitzt, wenn also bei der Definition des Koeffizienten $\alpha$ mit

$$\alpha = \frac{|R\_| - R_m}{2 \cdot L_m} \tag{18}$$

und der Frequenz $\omega$ durch

$$\omega^2 = \frac{1}{L_m \dfrac{C_m \cdot C\_}{C_m + C\_}} \tag{19}$$

der negative Widerstand R_ einen betragsmäßig größeren Wert aufweist als der Resonanzwiderstand $R_m$. Dies führt also zu folgender notwendigen Voraussetzung für eine aufklingende Lösung des Systems:

$$|R\_| > R_m \tag{20}.$$

**Abschätzungen der exponentiellen Dynamik**

Für die weitere Diskussion wird, jedoch ohne Einschränkung der Allgemeingültigkeit, zunächst ein passender Phasenwinkel festgelegt, in diesem Fall $\vartheta = 90°$.

Es ist jedoch auch jede andere Festlegung des Phasenwinkels $\vartheta$ möglich.

Nach einigen Umformungen gilt für den zeitabhängigen Strom durch den Serienarm des Resonators sowie die zeitabhängige, an der Resonatorkapazität $C_m$ abfallende Spannung:

$$I_L(t) = -I_L(0) \cdot e^{\alpha \cdot t} \cdot \sin(\omega \cdot t) \tag{21}.$$

$$U_C(t) = U_C(0) \cdot e^{\alpha \cdot t} \cdot \cos(\omega \cdot t)$$

Beginnend bei einer Zeit t = 0 wird somit durch die Wahl des Phasenwinkels $\vartheta$ das System ausgehend vom Nulldurchgang des Resonatorstroms $I_L(t)$ betrachtet, und zwar von positiven nach negativen Werten.

Nach exakt einer Periode wird das System eine Spannungsamplitude von

$$U_C(T) = U_C(0) \cdot e^{\alpha \cdot T} \tag{22}$$

erreicht haben.

Berücksichtigt man, daß der Koeffizient $\alpha$ im allgemeinen nicht konstant ist, beschreibt eben dieser Koeffizient $\alpha$ die für jeden beliebigen Zeitpunkt t gültige Dynamik der elektrischen Größen des Resonators über eine Periode der zugrundeliegenden Schwingung.

Für den allgemeinen Fall einer anders festgelegten Phase, also für $\vartheta$ ungleich 90°, wäre die Dynamik des Stromes nach

$$I_L(t) = I_L(0) \cdot e^{\alpha \cdot T} \tag{23}$$

7

auswertbar.

Eine reziproke Anschwingzeitkonstante $\alpha_0$ in dem Arbeitspunkt wird definiert durch

$$\alpha(t = 0)|_{AP} = \alpha_0 = \frac{1}{\tau_R} = \frac{|R\_| - R_m}{2L_m} \tag{24}.$$

Hierbei muß festgestellt werden, daß der Anfangszustand des gesamten Netzwerks durch eine Arbeitspunktberechnung ermittelt wird.

Der Term $e^{\alpha T}$ aus Formel (22) kann umgeschrieben werden in:

$$e^{\alpha \cdot T} = \frac{U_C(T)}{U_C(0)} = 1 + \Delta \tag{25}.$$

Es zeigt sich, daß ein Störtherm $\Delta$ in Formel (25) immer klein gegenüber Eins ist. Hierbei ist allerdings zu bemerken, daß die maximale Größe des Störtherms $\Delta$ durch die Materialeigenschaften des Resonators selbst bestimmt ist und sich der maximale Wert des Störtherms $\Delta_{max}$ ergibt aus:

$$\Delta_{max} = \frac{\pi}{2r} \tag{26}.$$

Eine Materialkonstante r ergibt sich aus:

$$r = \frac{\pi^2 \cdot N^2}{8} \cdot \frac{c \cdot \kappa \cdot \varepsilon_0}{e^2} \tag{27}.$$

Hierbei bezeichnen

N     den Schwingungsmodus (N = 1: Grundwelle),
c     den Koeffizienten der elastischen Steifigkeit,
k     die effektive dielektrische Konstante,
e     die piezoelektrische Konstante,
$\kappa$     den piezoelektrischen Kopplungskoeffizienten, sowie
$\varepsilon_0$     die elektrische Suszeptibilität.

Die vom physikalischen Bereich in die äquivalenten Werte des elektrischen Ersatzschaltbildes transformierten und üblicherweise zu exzessiven Rechenzeiten führenden materiellen Eigenschaften des Quarzresonators erlauben nunmehr die zunächst einmal lokal, das heißt mindestens über einer Periode gültige Modellierung des Serienarms des Quarzresonators als eine sinusförmige Stromquelle $I_S(t)$ in der Form:

$$_S(t) = I_S \cdot \sin(\omega \cdot t) \tag{28}.$$

Die initiale Amplitude $I_S$ des Serienarms sowie die Frequenz $\omega$ sind hinreichend genau zu bestimmen. Damit ergibt sich, daß der Quarzresonator in genügender Näherung lokal, also mindestens über eine Periode als eine unabhängige Stromquelle modelliert werden kann.

Es ist jedoch zu betonen, daß diese Modellierung des Serienschwingkreises durch eine sinusförmige Stromquelle nicht nur im eingeschwungenen Zustand gültig ist, sondern auch das Verhalten während des Einschwingens adäquat beschreibt. Dies bedeutet, die eben beschriebenen potentiellen Modellierungsmöglichkeiten gelten für alle Zeitpunkte während des Einschwingens der Quarzresonatorschaltung, also für alle Zeitpunkte in dem Zeitintervall $[0,t_l]$.

**Dominanz des Resonatorstromes.**

Der nur auf der ersten harmonischen auftretende Resonatorstrom $I_S(t)$ kann wie im vorigen beschrieben, durch eine Quellensubstitution „emuliert" werden. Der wichtigste Parameter hierfür, die Initialamplitude des Stromes des dynamischen Arms des Quarzresonators kann dabei zunächst beliebig vorgegeben werden. Nach einer solchen Substitution verbliebe als unbekannte Größe noch die Spannung, die an dem gesamten Quarzresonator abfällt. Um diese mit dem Resonatorstrom zu korrelieren bzw. aus diesem ableiten zu können, wird eine weitere, für das erfindungsgemäße Verfahren entscheidende Annahme getroffen.

Diese Annahme lautet:

Bezüglich des Verhältnisses der Resonator-Zeitkonstante zu der Arbeitspunkt-Konstante $\tau_{AP}$ wird der Einschwingvorgang als resonatordominiert unterstellt. Als Verhältnis der eingeführten Zeitkonstanten ausgedrückt bedeutet dies:

$$\tau_{AP} << \tau_R = \frac{1}{\alpha_0} = \frac{2 \cdot L_m}{|R\_| \cdot R_m} \qquad (29).$$

Das Erreichen des Arbeitspunktes sowie dessen im weiteren Verlaufe des Einschwingens auftretende Verschiebung sind somit als eingebettet in den durch den Resonator bestimmten Einschwingvorgang anzusehen.

Daraus folgt insbesondere, daß alle relevanten Verschiebungen des Arbeitspunktes AP abgeschlossen sind, solange die Schaltung im linearen Betrieb arbeitet.

Durch die Substitution der Quelle kann somit ein Verhalten der übrigen Schaltung erzwungen werden, welches von der Größe der jeweils eingeprägten Amplitude, also beispielsweise der Initialamplitude des Stromes des dynamischen Arms des Quarzresonators, abhängt. Die Annahme einer Dominanz des Resonatorstromes und das Einprägen der Stromquelle liefert nun die Möglichkeit, die zweite unbekannte Größe, die externe Resonatorspannung, zu ermitteln.

Die Substitution der unabhängigen Stromquelle stellt eine Zwangsbedingung dar, die dem verbleibenden nichtlinearen Netzwerk die elektrischen Größen des Resonators „aufzwingt".

Kombiniert man diese Zwangsbedingung mit der Annahme des resonatordominierten Einschwingvorgangs, also der Annahme der dominanten Resonatorzeitkonstante $\tau_R$ des dynamischen Arms des Resonators, alle anderen dynamischen Vorgänge im Netzwerk sind durch entweder etwa gleich große oder - im besten Fall - kleinere Zeitkonstanten charakterisiert, die dem Resonator internen Anschwingvorgang schnell genug folgen können, ergibt sich unter Einfluß der restlichen Annahmen ein verbal wie folgt zu formulierender Ablaufplan für das Verfahren zur Bestimmung des Einschwingverhaltens einer Quarzresonatorschaltung.

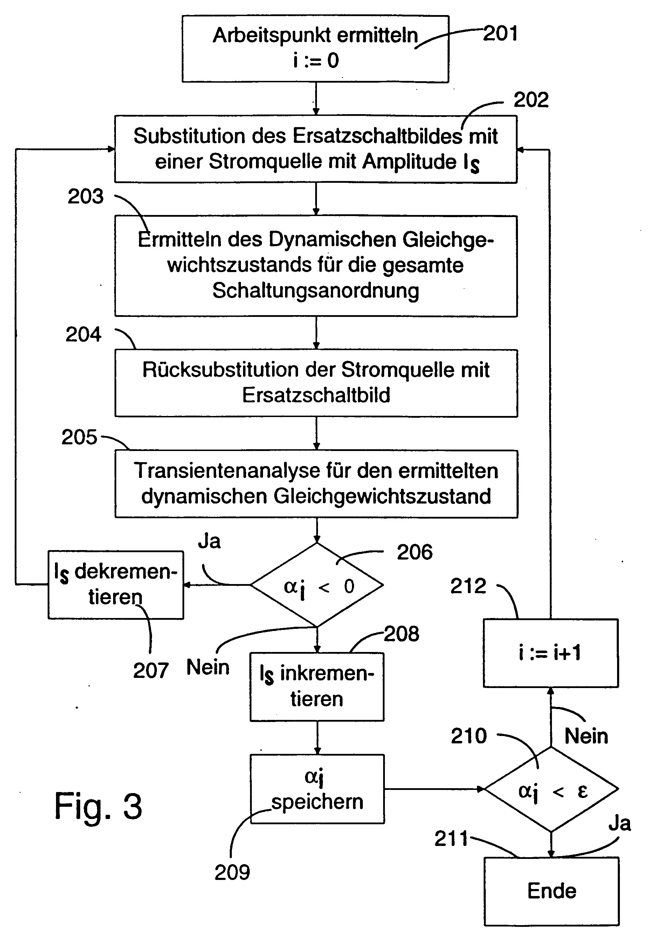

Dieses Verfahren ist in einem Ablaufdiagramm in Figur 3 dargestellt.

Das Verfahren wird notwendigerweise von einem Rechner durchgeführt.

Für einen ersten Zeitpunkt t = 0 wird der Arbeitspunkt AP der Quarzresonatorschaltung ermittelt 201.

Weiterhin wird die initiale Amplitude des Stroms im dynamischen Arm des Resonators bestimmt.

Einem Zählindex i wird ein Anfangswert Null zugewiesen.

In einem weiteren Schritt wird nun eine unabhängige Stromquelle substituiert mit gegebener Amplitude $I_S$ und einer Frequenz $\omega \approx \omega_S$ 202. Hierbei bezeichnet $\omega_S$ die Schwingungsfrequenz des von der substituierten Stromquelle gelieferten Stroms.

Für die Quarzresonatorschaltung mit der substituierten Stromquelle wird nun ein dynamischer Gleichgewichtszustand ermittelt 203.

Dies erfolgt durch bekannte Verfahren, beispielsweise durch das sogenannte Schießverfahren oder auch durch das Verfahren der Harmonischen Balance. Diese Verfahren sind in [6] beschrieben.

Nachdem der dynamische Gleichgewichtszustand ermittelt wurde, erfolgt eine Rücksubstitution des Ersatzschaltbildes des Quarzresonators für die substituierte Stromquelle 204.

Für diese nun wieder „ursprüngliche" Schaltungsanordnung werden für den dynamischen Gleichgewichtszustand nunmehr im Zeitbereich mittels der sogenannten Transientenanalyse [1] mit unter Umständen problemangepaßten modifizierten Integrationsverfahren durchgeführt 205.

Numerische Integrationsverfahren, die in diesem Verfahren eingesetzt werden können, sind dem Fachmann hinlänglich bekannt.

Diese können beispielsweise die sogenannten Euler-Verfahren (implizites Euler-Verfahren, explizites Euler-Verfahren) oder auch die sogenannte Trapez-Integration verwendet werden. Weitere numerische Integrationsverfahren sind dem Fachmann hinlänglich bekannt [1]. Diese können ohne Einschränkung in dem erfindungsgemäßen Verfahren eingesetzt werden.

Für jeden Iterationsschritt, der durch den Rechner durchgeführt wird, und durch den jeweiligen Zählindex i gekennzeichnet wird, wird abhängig von dem Wert des Zählindexes i die im folgenden beschriebene Vorgehensweise verfolgt.

Zu Beginn des Verfahrens, also für den Zählindex i = 0 wird untersucht, ob die reziproke Anschwingzeitkonstante im Arbeitspunkt $\alpha_0 < 0$ ist.

Ist dies der Fall, so ist die Schaltung nicht schwingfähig und das Verfahren wird beendet.

Für alle weiteren Iterationsschritte des Verfahrens, also für alle Werte des Zählindex i > 0 wird überprüft, ob eine jeweils auf dieselbe Weise, wie die reziproke Anschwingzeitkonstante am Arbeitspunkt ermittelte Wachstumsrate $\alpha_i$ der Amplitude des Strom des dynamischen Arms des Quarzresonators ermittelt und für die Wachstumsrate $\alpha_i$ untersucht, ob diese einen positiven oder einen negativen Wert aufweist 206.

Weist die Wachstumsrate $\alpha_i$ in dem jeweiligen Iterationsschritt i einen negativen Wert auf, so wird für den im weiteren beschriebenen nächsten Iterationsschritt i+1 das Verfahren durchgeführt mit einem Wert der initialen Amplitude $I_S$ des Stroms der substituierten Quelle, der reduziert wurde 207.

Ist jedoch die Wachstumsrate $\alpha_i > 0$, so wird das Verfahren in der nächsten Iterationsschleife durchgeführt mit einer erhöhten initialen Amplitude $I_S$ des Stroms des dynamischen Arms des Quarzresonators und somit der substituierten Quelle 208.

In diesem Fall wird die Wachstumsrate $\alpha_i$ gespeichert 209.

Weiterhin wird für den Fall, daß die Wachstumsrate $\alpha_i > 0$ ist, auf der Basis der Summe $\alpha_i + \alpha_{i-1}$ die zwischen beiden Zuständen vergangene Zeit ermittelt.

Liegt der Wert der Wachstumsrate $\alpha_i$ über dem Wert 0, jedoch unter dem Wert einer vorgebbaren Schranke $\varepsilon$ und ist somit der Betrag von $R_.$ Minus dem Resonatorwiderstand $R_m < \varepsilon$ 210, wird die Berechnung beendet 211.

Andernfalls wird der Zählindex i um den Wert 1 erhöht 212, der Amplitudenwert $I_S$ der Stromquelle jeweils abhängig von der Wachstumsrate $\alpha_i$ erhöht, wie im vorigen beschrieben wurde, und das gesamte Verfahren beginnend mit der Substitution der unabhängigen Stromquelle 202 mit dem nunmehr gewählten Amplitudenwert $I_S$ der Stromquelle wird von neuem gestartet.

Ist für einen Iterationsschritt die Wachstumsrate $\alpha_i > 0$, wird der Wert der Wachstumsrate $\alpha_i$ für den jeweiligen Iterationsschritt gespeichert 209.

Ist der Wert der Wachstumsrate jedoch $\alpha_i < 0$, wird dieser Wert nicht gespeichert.

Aus den gespeicherten Wachstumsraten $\alpha_i$ kann nunmehr näherungsweise eine Bestimmung der Einschwingzeit $t_f$ erfolgen. Diese ergibt sich vorzugsweise aus der Summe aller berechneten Zeitschritte $\Delta t_i$, für die die Proportionalität

$$(\Delta t)_i = t_i - t_{i-1} \propto (\alpha_i + \alpha_{i-1})^{-1} \tag{30}$$

wie im folgenden noch näher beschrieben wird, gilt.

Mit den Zeitschritten $(\Delta t)_i$ zu dem jeweiligen Iterationsschritt i ist der Abstand auf der Zeitachse zwischen zwei sukzessiven Werten von $I_L$ bzw. $I_S$ bezeichnet. Nähert sich der Betrag des an den Klemmen des Quarzresonators wirksamen negativen Widerstandes Betrag $R_.$ dem Wert von dem Resonatorwiderstand $R_m$ an, ist also

$$|R_.| - R_m < \varepsilon \tag{31}$$

mit der geeignet gewählten Schranke $\varepsilon$, kann der Einschwingvorgang als abgeschlossen angesehen werden.

Die sukzessive Erhöhung der Amplitude $I_S$ der substituierten Quelle bei Werten der Wachstumsrate $\alpha_i$, das sogenannte Source Stepping geht nach für den Fachmann bekannten Regeln vor sich.

Hervorzuheben ist hierbei, daß der Grenzzyklus des Systems dann als erreicht angesehen werden kann, wenn die innerhalb des Quarzresonators während eines Zyklus verbrauchte elektrische Energie diesem während dieses Zyklus auch wieder zugeführt wird, so daß der Quarzresonator und die Schaltung im energetischen Sinne im Gleichgewicht stehen.

Der entscheidene Vorteil dieses betreffs seiner einzelnen Bestandteile im folgenden noch genauer zu spezifizierenden Verfahrens besteht darin, daß, wie im vorigen beschrieben wurde, das Hochfahren der substituierten Quelle in verglichen mit der Periodendauer der oszillatorischen Schwingung großen Schritten erfolgen kann.

Das bedeutet, daß den einzelnen deutlich separierten Amplitudenwerten $I_S$ der Quelle auf der Zeitachse ein Abstand von unter Umständen mehreren zehntausend Perioden entspricht. Somit wird die Einschwingcharakteristik nur punktweise und, versehen mit einer passenden Phasenbedingung, der Einhüllenden folgend, berechnet. Aus diesen lokal extrahierten Größen wird das globale Verhalten rekonstruiert und somit die Einschwingzeit bestimmt.

Zu Beginn des Verfahrens wird also wie im vorigen beschrieben, eine Arbeitspunktbestimmung durchgeführt 201. Dies erfolgt durch eine sogenannte DC-Analyse. Durch die beiden Kapazitäten $C_m$ und $C_0$ ist der Quarzresonator während dieser Analyse im Netzwerk nicht wirksam.

Der Ausdruck zur Ermittlung der initialen Amplitude des Resonatorstroms lautet, wie im vorigen beschrieben wurde:

$$I_{L,0} = U_{R,0} \cdot \omega \cdot C_m \cdot \frac{1}{\sqrt{1 + \omega^2 \cdot \tau_0^2}} \tag{32}.$$

Für die Größe $U_{R,0}$ wird der ermittelte Wert für den Arbeitspunkt AP verwendet, die Größe $\tau_0$ weist einen Default-Wert 0 auf.

Von der Anwendeseite ist eine Manipulation des Ausdrucks der Formel (32) durch Eingabe der Zeitkonstanten $\tau_0$ möglich. Mit dieser Maßnahme können unter Umständen kritische Einschaltprozeduren nachgebildet werden, wenn nicht sicher ist, ob der dadurch induzierte Strom eine ausreichende Größe besitzt, um das System zum Anschwingen zu bringen.

Die Substitution durch die Quelle wandelt das ursprünglich zeit-periodische System in ein nicht autonomes um.

Für die Ermittlung des Zustandsvektors des Systems ist bei Vorgabe von Frequenz und Amplitude der Stromquelle somit ein erzwungenes Schwingungsproblem der Form

$$y(T)=y(0) \tag{33}$$

zu lösen, wobei mit T die Periode beschreibt, sich also ergibt aus

$$T = \frac{2\pi}{\omega}.$$

Für diese Aufgabe existieren als bekannteste Vertreter die Schießverfahren sowie die Verfahren der Harmonischen Balance [6]. Die Einspeisung durch ein solches Verfahren und für einen bestimmten Quellenwert ermittelten Zustandsvektors

$$y(T) = y(0)$$

in das ursprüngliche Netzwerk wird ein neues Anfangswertproblem

$$F(y, \dot{y}, t_i) = 0 \qquad \text{mit } t_i \leq t \leq t_i + p * T$$

mit bekanntem y(0), dessen Lösung über eine oder mehrere Perioden das für $t_i...t_i+ p * T$, $1 \leq p \leq p_{max}$ gültige dynamische Verhalten liefert.

Die hier eingeführte Größe $p_{max}$ stellt einen Verfahrensparameter dar, der die maximale Anzahl zu integrierender Perioden innerhalb der Transientenanalyse vorschreibt. Durch den endlich großen Abbruchfehler von Schießverfahren oder Verfahren der Harmonischen Balance ergeben sich im allgemeinen noch relativ schnelle Ausgleichsvorgänge, so daß ein Wert $p_{max} = 2$ als notwendig, aber auch als hinreichend ermittelt wurde.

Daraus läßt sich relativ leicht die Wachstumsrate $\alpha_i$ nach folgender Vorschrift bestimmen:

$$\alpha_i = \frac{1}{T} \ln\left(\frac{U_C(t_i + pT)}{U_C(t_i + (p-1)T)}\right) \tag{34}.$$

Es wird also nach Bestimmung des dynamischen Gleichgewichtszustands durch Schießverfahren oder durch ein Verfahren der Harmonischen Balance 203 und nach Rücksubstitution 204 für den jeweiligen dynamischen Gleichgewichtszustand eine Transientenanalyse durchgeführt 205.

Aus der Wachstumsrate $\alpha_i$ werden nunmehr Zeitschritte $\Delta t_i$ ermittelt. Es hat sich als vorteilhaft herausgestellt, die Zeitschritte $\Delta t_i$ nach folgender Vorschrift zu bestimmen

$$(\Delta t)_i = (n-1)T = \frac{2}{\alpha_{i-1} + \alpha_i} \cdot \ln\left(\frac{U_C(n \cdot T)}{U_C(T)}\right) \tag{35}$$

Die genaue Bedeutung der einzelnen Größen innerhalb des Verfahrens ist wie folgt:

$U_C(T)$ bezeichnet die an der Resonatorkapazität des Serienarms abfallende Spannung.

Korrespondierend dazu ist die Wachstumsrate $\alpha_{i-1}$ im Resonator für den Zeitpunkt $t_{i-1}$ gültige Wert.

$U_c((n-1) \times T)$ ist der Startwert der nächsten Transienten-Analyse.

$$U_C((n-1)T) = r_i \cdot U_C(T) \tag{36}$$

stellt einen zunächst einmal geschätzten Wert für die an der Resonatorkapazität des Serienarms abfallende Spannung dar.

$r_i \in \Re$, $r_i > 1$ ist eine im Laufe der Berechnung geeignet zu bildende, monoton fallende Sequenz, die eine Vorschrift für das Hochfahren der Stromquelle liefert.

Man kann anschaulich von einem Prädiktorwert für die an der Resonatorkapazität des Serienarms abfallende Spannung $U_C$ sprechen, der allerdings nur dann korrigiert werden kann, wenn für die daraus ableitbare Dynamik $\alpha_i > 0$ gilt. Anderenfalls muß der Prädiktorwert verworfen werden.

Wird $U_C((n-1)T)$ akzeptiert, dann wird durch die folgende Vorgehensweise

$$\frac{2}{\alpha_{i-1} + \alpha_i} \cdot \ln\left(\frac{U_C(n \cdot T)}{U_C(T)}\right) \cong \frac{2}{\alpha_{i-1} + \alpha_i} \cdot \ln(r_i) \tag{37}$$

der im Rahmen der Linearisierung von $\alpha(t)$ exakte zeitliche Abstand zwischen dem letzten berechneten Wert, $U_C(T)$, und dem aktuellen Wert $U_C(n \times T)$ dar.

$U_C(n * T)$ ist der Endwert eben dieser Analyse, wenn lediglich eine Periode berechnet wird.

Es ist nicht notwendig, die Vorschrift (35) zur Bildung der einzelnen Zeitschritte $(\Delta t)_i$ heranzuziehen. Auch andere Abhängigkeiten, beispielsweise durch Polynome ausgedrückt, sind in diesem Rahmen einsetzbar. Wichtig ist hierbei jedoch die Berücksichtigung der indirekten Proportionalität der inkrementellen Zeitschritte $(\Delta t)_i$ zu den inkrementellen Änderungen der Wachstumsraten $\alpha_i$, wie in Formel (30) dargestellt wurde.

Insgesamt ergibt sich am Ende des Verfahrens die Einschwingzeit $t_f$ zu

$$t_f = \sum_{i=1} \frac{2}{\alpha_i + \alpha_{i-1}} \cdot \ln(r_i) = \sum_{i=1} (\Delta t)_i \qquad (38).$$

Dieses Verfahren wird notwendigerweise durch einen Rechner durchgeführt.

Folgende Veröffentlichungen wurden im Rahmen dieser Schrift zitiert:

[1] U. Feldmann et al, Algorithms for Modern Circuit Simulation, AEÜ, Vol. 46, No. 2, Hirzel-Verlag Stuttgart, S. 274 - 285, 1992

[2] I. Ivanisevic, The Quartz Crystal Oscillator Realization Using Current Conveyors, IEEE Transactions on Circuits and Systems-I: Fundamental Theory and Applications , Vol. 40, No. 8, S. 530 - 533, August 1993

[3] L. Dworsky et al, A Simple Single Model for Quartz Crystal Resonator Low Level Drive Sensitivity and Monolithic Filter Intermodulation, IEEE Transactions on Ultrasonics, Ferroelectrics and Frequency Control, Vol. 41, No. 2, S. 261 - 268, März 1994

[4] A. Rusznyak, Start-Up Time of CMOS Oscillators, IEEE Transactions on Circuits and Systems, Vol. 34, No. 3, S. 259 - 268, März 1987

[5] N. Nguyen et al, Start-up and Frequency Stability in High-Frequency Oscillators, IEEE Journal of Solid-State Circuits, Vol. 27, No. 5, S. 810 - 820, Mai 1992

[6] K. Kundert et al, Techniques for Finding the Periodic Steady-State Response of Circuits, Analog Methods for Computer-Aided Circuit Analysis and Diagnosis, T. Ozawa (ed.), Marcel Dekker Inc., ISBN 0-8247-7843-0, S. 169 - 203, 1988)

**Patentansprüche**

1. Verfahren zur rechnergestützten iterativen Bestimmung des Einschwingverhaltens einer Quarzresonatorschaltung durch einen Rechner,

  a) bei dem eine initiale Amplitude des Stroms des dynamischen Arms des Quarzresonators ermittelt wird,
  b) bei dem der Arbeitspunkt der Quarzresonatorschaltung ermittelt wird (201),
  c) bei dem eine Erschatzschaltung des Quarzresonators ersetzt wird durch eine Stromquelle mit der initialen Amplitude des Stroms des dynamischen Arms des Quarzresonators (202),
  d) bei dem für die Quarzresonatorschaltung mit der substituierten Stromquelle der dynamische Gleichgewichtszustand ermittelt wird (203),
  e) bei dem die Stromquelle ersetzt wird durch die Erschatzschaltung des Quarzresonators (204),
  f) bei dem für den dynamischen Gleichgewichtszustand der Quarzresonatorschaltung mittels einer Transientenanalyse eine Wachstumsrate $(\alpha i)$ der Amplitude des Stroms des dynamischen Arms des Quarzresonators ermittelt wird (205),
  g) bei dem die Schritte b) bis f) durchgeführt werden für jeweils

  - einen in der Amplitude erhöhten Strom des dynamischen Arms des Quarzresonators falls die Wachstumsrate $(\alpha_i)$ größer als Null ist (206, 208, 209), und
  - einen in der Amplitude erniedrigten Strom des dynamischen Arms des Quarzresonators falls die Wachstumsrate $(\alpha_i)$ kleiner als Null ist (206, 207),

  solange bis die jeweilig aktuelle Wachstumsrate $(\alpha_i)$ kleiner ist als eine vorgebbare Schwelle $(\varepsilon, 210, 211, 212)$,

und

h) bei dem aus der iterativ bestimmten Folge der Wachstumsrate ($\alpha_i$) das Einschwingverhaltens der Quarzresonatorschaltung bestimmt wird.

2. Verfahren nach Anspruch 1,
bei dem zur Bestimmung des dynamischen Gleichgewichtszustands das Schießverfahren verwendet wird.

3. Verfahren nach Anspruch 1,
bei dem zur Bestimmung des dynamischen Gleichgewichtszustands das Verfahren der Harmonischen Balance verwendet wird.

4. Verfahren nach Anspruch 1 oder 2,
bei dem als Ersatzschaltung einer zu modellierenden Schaltung (SCH) ein Negativ-Widerstands-Modell verwendet wird.

5. Verfahren nach einem der Ansprüch 1 bis 4,

-   bei dem aus der Folge der Wachstumsrate ($\alpha i$) eine Folge von Zeitschritten ($\Delta ti$) bestimmt wird, und
-   bei dem die Einschwingzeit der Quarzresonatorschaltung sich ergibt aus der Summe der Folge von Zeitschritten ($\Delta ti$).

6. Verfahren nach Anspruch 5,
bei dem sich die Einschwingzeit der Quarzresonatorschaltung ergibt aus

$$ f = \sum_{i=1}^{n} \frac{2}{\alpha_i + \alpha_{i-1}} \cdot \ln(r_i) \cong \sum_{i=1}^{n} \frac{2}{\alpha_i + \alpha_{i-1}} \cdot \ln\left(\frac{U_C(nT)}{U_C(T)}\right) = \sum_{i=1}^{n} \Delta t_i $$

wobei

$r_i$     einen Prädiktorwert für eine an der Resonatorkapazität des Serienarms abfallende Spannung ($U_C$) bezeichnet,

$U_C(T)$     einen zuletzt ermittelten Wert der an der Resonatorkapazität des Serienarms abfallenden Spannung bezeichnet, und

$U_C(nT)$     den Endwert der Analyse bezeichnet, wenn lediglich eine Periode ermittelt wird.

Fig. 1

# Fig. 2

Fig. 3

Flussdiagramm:

- 201 — Arbeitspunkt ermitteln  i := 0
- 202 — Substitution des Ersatzschaltbildes mit einer Stromquelle mit Amplitude $I_S$
- 203 — Ermitteln des Dynamischen Gleichgewichtszustands für die gesamte Schaltungsanordnung
- 204 — Rücksubstitution der Stromquelle mit Ersatzschaltbild
- 205 — Transientenanalyse für den ermittelten dynamischen Gleichgewichtszustand
- 206 — $\alpha_i < 0$
- 207 — $I_S$ dekrementieren (Ja)
- 208 — $I_S$ inkrementieren (Nein)
- 209 — $\alpha_i$ speichern
- 210 — $\alpha_i < \varepsilon$
- 211 — Ende (Ja)
- 212 — i := i+1 (Nein)